# EUROPEAN PATENT APPLICATION

(11) **EP 0 810 708 A2**
(43) Date of publication of application: **03.12.1997**
(21) Application number: 97108486.8
(22) Date of filing: 26.05.1997
(51) Int. Cl.: H02H 9/04

(54) **Semiconductor device having individual power supply lines shared between function blocks for discharging surge without propagation of noise**

(30) Priority: 30.05.1996 JP 136694/96
(71) Applicant: NEC CORPORATION, Tokyo (JP)
(72) Inventor: Imamura, Hiroshisa, Minato-ku, Tokyo (JP)
(74) Representative: Baronetzky, Klaus, Dipl.-Ing.

(57) **Abstract**

Digital circuits (32c) undesirably producing noise and an analog circuit (32e) sensitive to the noise are fabricated on a single semiconductor chip (31), and are powered through a first set of positive power supply line and ground line (VDD10/GND10) and a second set of positive power supply line and ground line (VDD11/GND11), respectively; normally-off type field effect transistors (Qn1/Qn2/Qn3) are selectively connected between the positive power supply lines and the ground lines, and are responsive to electro-static surge voltage so as to turn on for discharging from one to another; however, the normally-off type field effect transistors do not turn on in the presence of the noise, thereby preventing the digital circuits and the analog circuit from the electro-static surge voltage and the noise.

## Description

### FIELD OF THE INVENTION

This invention relates to a semiconductor device and, more particularly, to a semiconductor integrated circuit device having individual power supply lines shared between function blocks for discharging static surge without propagation of noise.

### DESCRIPTION OF THE RELATED ART

A semiconductor integrated circuit device is powered through a plurality of power supply pins and ground pins, and the power voltage and the ground voltage are distributed from the pins to component circuits. The components circuit usually contains a plurality of field effect transistors, and the field effect transistors are liable to be damaged due to static surge. For this reason, a protective means is incorporated in the semiconductor integrated circuit device. The power supply pins and the ground pins may be connected through metal wirings.

Another problem inherent in the semiconductor integrated circuit device is a malfunction due to noise, and the noise is propagated through the power supply line and the ground line to the component circuits. Electrical isolation between a noise source such as an output buffer circuit and the component circuits is effective against the malfunction. For example, a power supply pin and a ground pin exclusively supply the power potential and the ground level to the output buffer circuit, and the other component circuits are powered through other power supply pins and other ground pins. Another countermeasure is disclosed in Japanese Patent Publication of Unexamined Application (JPA) No. 4-65867, and the Japanese Patent Publication of Unexamined Application proposes to connect a plurality of power supply pins through a resistive element and a plurality of ground pins through another resistive element.

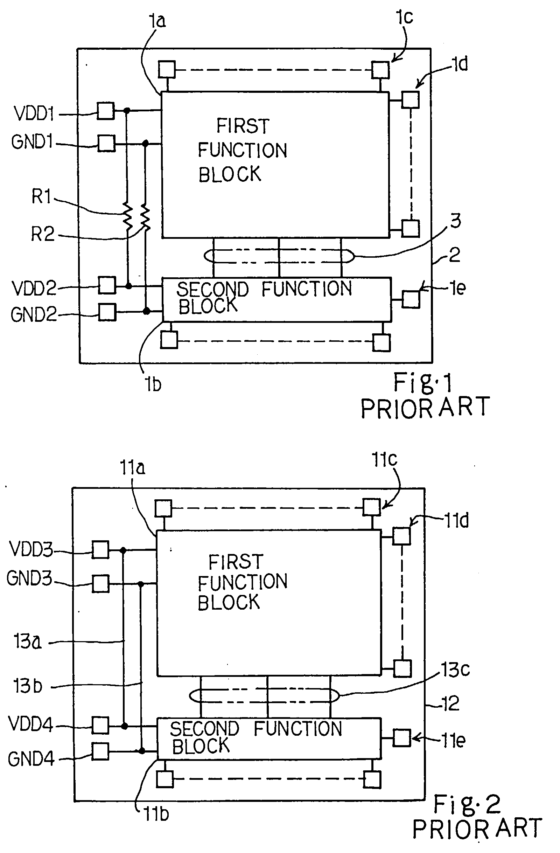

Figure 1 illustrates the semiconductor integrated circuit device disclosed in the above mentioned Japanese Patent Publication of Unexamined Application. A first function block 1a and a second function block 1b are integrated on a semiconductor chip 2, and pads 1c, 1d and 1e are provided on the semiconductor chip 2 around the first and second function blocks 1a/1b for electric signals. Though not shown in figure 1, input protection circuits are incorporated in the first and second function blocks 1a/1b, and prevent the circuit components of the first and second function blocks 1a/1b from static surge.

Power supply pins VDD1/VDD2 and ground pins GND1/GND2 are further provided on the semiconductor chip 2. The power supply pin VDD1 and the ground pin GND1 are connected to the first function block 1a, and the other power supply pin VDD2 and the ground pin GND2 are connected to the second function block 1b. The power supply pin VDD1 and the ground pin GND1 are connected through resistive elements R1 and R2 to the power supply pin VDD2 and the ground pin GND2, respectively. Thus, the first function block 1a and the second function block 1b are independently powered, and communicate with each other through signal lines 3.

The first function block 1a is a source of noise, and the second function block 1b is sensitive to the noise. For this reason, two sets of power supply pins VDD1/VDD2 and the ground pins GND1/GND2 independently supply the power potential and the ground level to the first and second function blocks.

If static surge is applied to one of the power supply pins VDD1/VDD2 or one of the ground pins GND1/GND2, the static surge is distributed through the resistive element R1 or R2 to both protective circuits of the first and second function blocks 1a/1b, and the protective circuits effectively discharge the static surge. However, the resistive elements R1/R2 provide a propagation path for the noise generated in the first function unit 1a. The noise is liable to be propagated from the first function block 1a through the resistive element R1/R2 to the second function block 1b, and causes a malfunction to take place in the second function block.

Figure 2 illustrates another prior art semiconductor integrated circuit device. The prior art semiconductor integrated circuit device also has a first function block 11a causative of noise and a second function block 11b sensitive to the noise such as an analog circuit. Both of the function blocks 11a/11b are fabricated on a semiconductor chip 12. Signal pads 11c, 11d and 11e are provided on the semiconductor chip 12 around the first function block 11a and the second function block 11b, and power supply pads VDD3/VDD4 and ground pads GND3/GND4 independently supply a power potential and the ground level to the first function block 11a and the second function block 11b. Protective circuits (not shown) are incorporated in the first and second function blocks 11a/11b, respectively.

The power supply pad VDD3 and the ground pad GND3 are connected through metal wirings 13a and 13b to the power supply pad VDD4 and the ground pad GND4, respectively, and the first and second function blocks 11a and 11b communicate through signal lines 13c with each other.

In this instance, the resistive elements R1/R2 are replaced with the metal wirings 13a/13b, respectively. The metal wiring 13a or 13b distributes static surge from the power supply pad VDD3/VDD4 or the ground pad GND3/GND4 to the protective circuits of both function blocks 11a/11b, and the static surge is effectively discharged through the protective circuits. However, the metal wirings 13a/13b propagate noise from the first function block 11a to the second function block 11b, and a malfunction tends to take place in the second function block 11b.

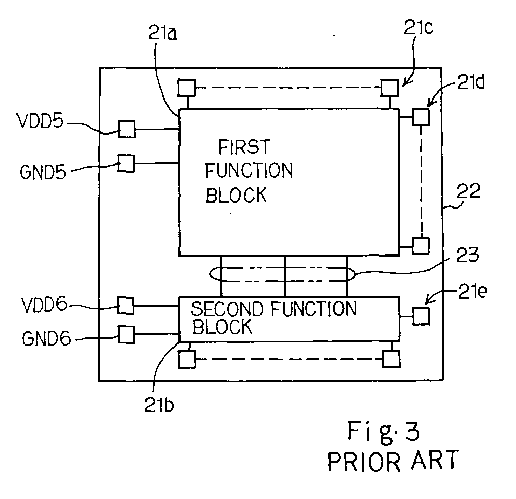

Figure 3 illustrates yet another prior art semiconductor integrated circuit device. The prior art semiconductor integrated circuit device also has a first function block 21a causative of noise and a second function block 21b sensitive to the noise. Both function blocks 21a/21b are fabricated on a semiconductor chip 22. Signal pads 21c, 21d and 21e are provided on the semiconductor chip 22 around the first function block 21a and the second function block 21b, and power supply pads VDD5/VDD6 and ground pads GND5/GND6 independently supply a power potential and the ground level to the first function block 21a and the second function block 21b. Protective circuits (not shown) are incorporated in the first and second function blocks 21a/21b, respectively. The first and second function blocks 21a and 21b communicate through signal lines 23 with each other.

No conductive line is connected between the power supply pad/ground pad VDD5/GND5 and the power supply pad/ground pad VDD6/GND6, and the power supply pad VDD5 and the ground pad GND5 are perfectly isolated from the power supply pad VDD6 and the ground pad GND6, respectively.

In this instance, the noise is never propagated to the second function block 21b, and, accordingly, no malfunction takes place due to the noise. However, when large static surge is, by way of example, applied to one of the power supply pins VDD5/VDD6 and the ground pins GND5/GND6 and one of the signal pads 21c/21e, the large static surge flows through the protective circuit into only one power supply/ground pin, and the only one protective circuit hardly discharges the large static surge. As a result, the static surge is propagated through the signal lines 23 between the first function block 21a and the second function block 21b, and the static surge damages the circuit components of the first and second function blocks 21a/21b.

Thus, there is a trade-off between the protection of noise and the discharge of large static surge.

### SUMMARY OF THE INVENTION

It is therefore an important object of the present invention to provide a semiconductor device which discharges large static surge without propagation of noise.

To accomplish the object, the present invention proposes to propagate only static surge between function blocks.

In accordance with the present invention, there is provided a semiconductor integrated circuit device comprising: a first function block having a first power supply line and a second power supply line, and causative of a noise on at least one of the first power supply line and the second power supply line; a second function block having a third power supply line and a fourth power supply line, and sensitive to the noise; a first power supply pad connected to the first power supply line for supplying a first power potential to the first function block; a second power supply pad connected to the second power supply line for supplying a second power potential different from the first power potential to the first function block; a third power supply pad connected to the third power supply line for supplying a third power potential to the second function block; a fourth power supply pad connected to the fourth power supply line for supplying a fourth power potential different from the third power potential to the second function block; and a switching means selectively connected to the first, second, third and fourth power supply lines, and changed from off-state to on-state for producing a conduction path therebetween in the presence of abnormal potential propagated through one of the first function block and the second function block, and the switching means remains in the off-state in the presence of the noise propagated through at least one of the first and second power supply lines.

### BRIEF DESCRIPTION OF THE DRAWINGS

The features and advantages of the semiconductor device according to the present invention will be more clearly understood from the following description taken in conjunction with the accompanying drawings in which:
Fig. 1 is a block diagram showing the circuit arrangement of the prior art semiconductor integrated circuit device disclosed in Japanese Patent Application of Unexamined Application No. 4-65867;
Fig. 2 is a block diagram showing the circuit arrangement of another prior art semiconductor integrated circuit device;
Fig. 3 is a block diagram showing the circuit arrangement of yet another prior art semiconductor integrated circuit device;
Fig. 4 is a block diagram showing the circuit arrangement of a semiconductor integrated circuit device according to the present invention;
Fig. 5 is a block diagram showing the circuit arrangement of another semiconductor integrated circuit device according to the present invention;
Fig. 6 is a block diagram showing the circuit arrangement of yet another semiconductor integrated circuit device according to the present invention; and
Fig. 7 is a circuit diagram showing the circuit configuration of a protective circuit against electric surge incorporated in the semiconductor integrated circuit device shown in figure 6.

### DESCRIPTION OF THE PREFERRED EMBODIMENTS

### First Embodiment

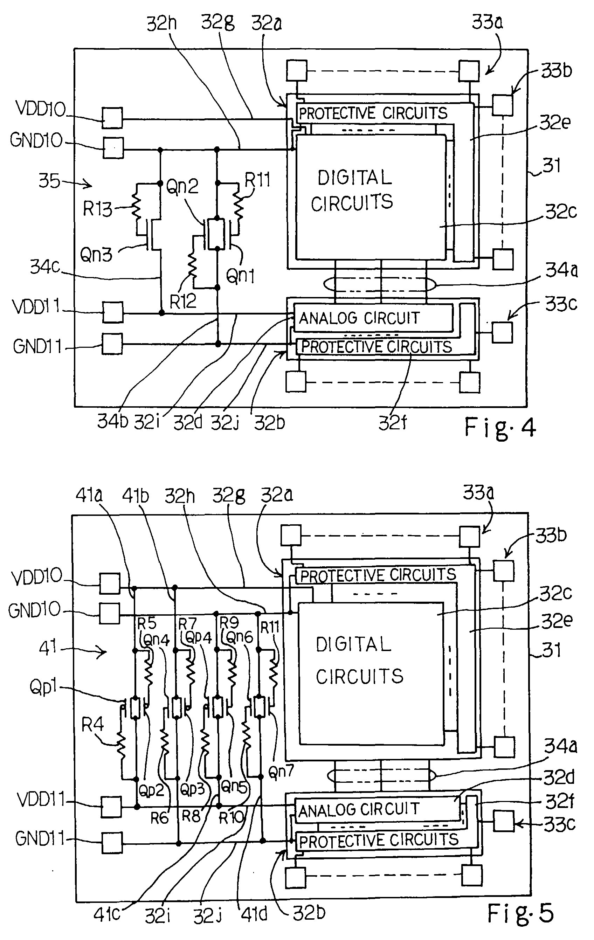

Referring to figure 4 of the drawings, a semiconductor integrated circuit embodying the present invention is fabricated on a semiconductor chip 31. The semiconductor integrated circuit device comprises a first function block 32a and a second function block 32b. The first function block 32a is implemented by digital circuits 32c, and some digital circuits such as, for example, output data buffers are a source of noise. On the other hand, the second function block 32b is implemented by at least one analog circuit 32d, and the analog circuit 32d is sensitive to the noise. Protective circuits 32e and 32f are connected between the signal pads 33a/33b and 33c and the digital/analog circuits 32c/32d, respectively, and discharge static surge.

The digital circuits 32c is connected between a power supply line 32g and a ground line 32h, and the protective circuits 32e are connected to the ground line 32h. Similarly, the analog circuit 32d is connected between a power supply line 32i and a ground line 32j, and the protective circuits 32f are connected to the ground line 32j.

The semiconductor integrated circuit device further comprises a plurality of signal pads 33a, 33b and 33c, power supply pads VDD10/VDD11 and ground pads GND10/GND11. Digital signals are supplied from and to an external device (not shown) through the signal pads 33a/33b, and the second function block 32b communicates with an external device (not shown) through the signal pads 33c. Power potential levels are supplied from an external power source (not shown) to the power supply pads VDD10/VDD11, and the ground potential is applied to the ground pads GND10/GND11. The first function block 32a is powered by the power supply pad VDD10 and the ground pad GND10, and the second function block 32b is powered by the power supply pad VDD11 and the ground pad GND11. The power potential level for the digital circuits is 5 volts, and the power potential of 3 volts is supplied to the analog circuit.

The semiconductor integrated circuit device further comprises signal lines 34a, a first conductive line 34b and a second conductive line 34c. The signal lines 34a are connected between the digital circuits 32c and the analog circuit 32d, and the digital circuits 32c and the analog circuit 32d communicate with each other through the signal lines 34a. The first conductive line 34b is connected between the ground pad GND10 and the ground pad GND11, and the second conductive line 34c is connected between the ground pad GND10 and the power supply pad VDD11.

The semiconductor integrated circuit device further comprises a pair of n-channel enhancement type switching transistors Qn1/Qn2 inserted into the first conductive line 34b and an n-channel enhancement type switching transistor Qn3. In this instance, the pair of n-channel enhancement type switching transistors Qn1/Qn2 is connected between the ground pads GND10 and GND11, because the power potential is different between the digital circuits 32c and the analog circuit 32d. However, only one n-channel enhancement type switching transistor may be connected between the ground pads GND10 and GND11 in another semiconductor integrated circuit device according to the present invention.

The n-channel enhancement type switching transistor Qn1 has a gate electrode connected through a resistor R11 to the ground pad GND10, and the other n-channel enhancement type switching transistor Qn2 has a gate electrode connected through a resistor R12 to the other ground pad GND11. Static surge causes the punch-through to take place in the n-channel enhancement-type switching transistors Qn1/Qn2.

The n-channel enhancement type switching transistor Qn3 has a gate electrode connected through a resistor R3 to the ground pad GND10, and static surge also causes the punch-through to take place in the n-channel enhancement type switching transistor Qn3. The resistors R1, R2 and R3 prevents the gate insulating layers of the n-channel enhancement type switching transistors Qn1, Qn2 and Qn3 from damage due to the static surge.

The n-channel enhancement type switching transistors Qn1, Qn2 and Qn3 have a threshold of 0.7 volt, and the noise is usually lower than 0.7 volt. In other words, the resistance of the conductive line is designed so as to make the noise lower than the threshold. On the other hand, static surge is much higher than the threshold, and causes the punch-through to take place in the n-channel enhancement type switching transistors Qn1, Qn2 and Qn3 so as to conduct the ground pads GND10/GND11 and the power supply pad VDD11 to one another. Thus, the n-channel enhancement type switching transistors Qn1 to Qn3 allows only static surge to pass therethrough.

In this instance, the power supply line 32g, the ground line 32h, the power supply line 32i and the ground line 32j respectively serve as a first power supply line, a second power supply line, a third power supply line and a fourth power supply line, and the n-channel enhancement type switching transistors Qn1/Qn2/Qn3, the first and second conductive lines 34b/34c and the resistors R11/R12/R13 as a whole constitute a switching means 35.

The n-channel enhancement type switching transistors Qn1, Qn2 and Qn3 behaves in the presence of noise and static surge as follows. While the digital circuits 32c are cooperating with the analog circuit 32d, noise is unavoidably produced in the digital circuits 32c, and the potential level at the ground pad GND10 fluctuates. The potential fluctuation or the noise is propagated through the ground line 32h to the n-channel enhancement type field effect transistors Qn1, Qn2 and Qn3. The power potential for the analog circuit 32d is applied to the source node of the n-channel enhancement type switching transistor Qn3, and the noise hardly causes the n-channel enhancement type switching transistor Qn3 to turn on. The ground voltage on the ground line 32j keeps the n-channel enhancement type switching transistors Qn2 off. Even though the noise is applied to the gate electrode of the n-channel enhancement type switching transistor Qn1, the noise does not exceed the threshold, and the n-channel enhancement type switching transistor Qn1 is turned off. Thus, the noise is never transferred to the analog circuit 32d, and no malfunction takes place in the analog circuit 32d due to the noise.

Even if the digital circuits 32c cause the potential level on the power supply pad VDD10 to fluctuate, the potential fluctuation does not affect the analog circuit 32d, because the analog circuit 32d is powered through the other power supply pad VDD11.

Assuming now that static surge is applied between the signal pad 33a/33b and the power supply/ground pad VDD11/GND11, the extremely high surge voltage is propagated through the protective circuits 32e and the ground line 32h to the n-channel enhancement type switching transistors Qn1/Qn2/Qn3. The extremely high surge voltage causes the punch-through to take place in the n-channel enhancement type switching transistors Qn1/Qn2/ Qn3, and the static surge is discharged through the power supply pad/ground pad VDD10/VDD11/GND10/GND11. Thus, the current discharging capability is increased rather than that of the prior art semiconductor integrated circuit device, and the static charge does not damage component transistors of the digital/analog circuits 32c/32d.

When static surge is applied between the power supply/ground pad VDD10/GND10 and one of the signal pads 33c, the extremely high surge voltage passes through the protective circuits 32f and the ground line 32j to the n-channel enhancement type switching transistors Qn1/Qn2/Qn3. The punch-through takes place in the n-channel enhancement type field effect transistors Qn1/Qn2/Qn3. As a result, the extremely high surge voltage is discharged to the ground/power supply pads GND11/GND10/VDD11.

As will be understood from the foregoing description, the n-channel enhancement type switching transistors Qn1/Qn2/Qn3 does not propagate the noise from the digital circuits 32c to the analog circuit 32d; however, these n-channel enhancement type switching transistors Qn1/Qn2/Qn3 selectively turn on so as to discharge the static surge. Thus, the semiconductor integrated circuit device according to the present invention effectively discharge the static surge to the power supply/ground pads without propagation of the noise.

### Second Embodiment

Figure 5 illustrates another semiconductor integrated circuit device embodying the present invention. The semiconductor integrated circuit device implementing the second embodiment is similar to the first embodiment except for a switching means 41. For this reason, component circuits and pads of the second embodiment are labeled with the same references as those designating corresponding circuits and pads of the first embodiment without detailed description.

The switching means 41 includes four conductive lines 41a/41b/41c/41d, a pair of p-channel enhancement type switching transistors Qp1/Qp2 inserted into the conductive line 41a, a parallel combination of an n-channel enhancement type switching transistor Qn4 and a p-channel enhancement type switching transistor Qp3 inserted in the conductive line 41b, a parallel combination of a p-channel enhancement type switching transistor Qp4 and an n-channel enhancement type switching transistor Qn5 and a pair of n-channel enhancement type switching transistors Qn6/Qn7 and resistors R5/R6/R7/R8/R9/R10/R11.

The gate electrode of the p-channel enhancement type switching transistor Qp1 is connected through the resistor R4 to the power supply pad VDD11, and the gate electrode of the p-channel enhancement type switching transistor Qp2 is connected through the resistor R5 to the power supply pad VDD10. The gate electrode of the n-channel enhancement type switching transistor Qn4 is connected through the resistor R6 to the ground pad GND11, and the gate electrode of the p-channel enhancement type switching transistor Qp3 is connected through the resistor R7 to the power supply pad VDD10. The gate electrode of the p-channel enhancement type switching transistor Qp4 is connected through the resistor R8 to the power supply pad VDD11, and the gate electrode of the n-channel enhancement type switching transistor Qn5 is connected through the resistor R9 to the ground pad GND10. The gate electrode of the n-channel enhancement type switching transistor Qn6 is connected through the resistor R10 to the ground pad GND11, and the gate electrode of the n-channel enhancement type switching transistor Qn7 is connected through the resistor R11 to the ground pad GND10.

The threshold of the n-channel enhancement type switching transistors Qn4 to Qn7 and the threshold of the p-channel enhancement type switching transistors Qp1 to Qp4 are larger in absolute value than the noise, and the n-channel enhancement type switching transistors Qn4 to Qn7 and the p-channel enhancement type switching transistors Qp1 to Qp4 are turned off during the normal operation of the digital circuits 32c and the analog circuit 32d. The power supply lines 32g/32i and the ground lines 32h/32j are designed so as to decrease the noise level smaller than the thresholds.

The switching means 41 behaves as follows. When the noise causes the power supply line 32g and the ground line 32h to fluctuate, the p-channel enhancement type switching transistors Qp1/Qp2 and the n-channel enhancement type switching transistors Qn6/Qn7 are turned off, because the potential level on the power supply line 32g and the potential level on the ground line 32h do not exceed the thresholds of those switching transistors Qp1/Qp2 and Qn6/Qn7. For this reason, the noise is never propagated to the power supply line VDD11 and the ground line GND11. The power potentials and the ground potential do not allow the other switching transistors Qn4/Qp3 and Qp4/Qn5 to turn on in spite of the noise.

When static surge is applied between one of the signal pads 33a/33b and the power supply/ground pad VDD11/GND11, the extremely high surge voltage is discharge through the protective circuits 32e to the ground line 32h, and punch-through takes place in the p-channel/n-channel enhancement type switching transistors so as to discharge the extremely high surge voltage to the power supply pad/ground pad VDD11/GND11. As a result, the extremely high surge voltage does not damage the component transistors of the first and second function blocks 32a/32b.

On the other hand, when the static surge is applied between one of the signal pads 33c and the power supply pad VDD10 or the ground pad GND10, the extremely high surge voltage is discharged through the protective circuits 32 to the ground line 32j, and the punch-through takes place in the p-channel/n-channel enhancement type switching transistors so as to discharge the extremely high surge voltage to the power supply pad/ground pad VDD10/GND10. As a result, the extremely high surge voltage does not damage the component transistors of the first and second function blocks 32a/32b.

Thus, the switching means 41 allows only the extremely high surge voltage to pass therethrough, and prevents the first and second function blocks 32a/32b from both of the static surge and the noise.

### Third Embodiment

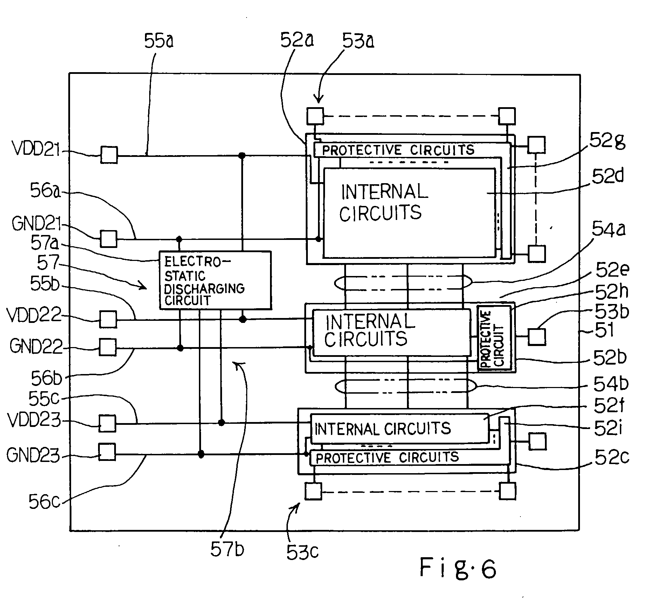

Figure 6 illustrates yet another semiconductor integrated circuit device embodying the present invention. The semiconductor integrated circuit device is fabricated on a semiconductor chip 51, and includes a function block 52a, which is a noise source, and two function blocks 52b and 52c both sensitive to the noise. The function blocks 52a/52b/52c have respective internal circuits 52d, 52e and 52f and respective protective circuits 52g, 52h and 52i for discharging static surge. The function blocks 52a/52b/52c communicate with external devices (not shown) through signal pads 53a/53b/53c, respectively, and signal lines 54a and 54b transfer internal signals between the function blocks 52a, 52b and 52c.

Power supply pads VDD21, VDD22 and VDD23 are connected through power supply lines 55a, 55b and 55c to the function blocks 52a, 52b and 52c, respectively, and ground pads GND21, GND22 and GND23 are connected through ground lines 56a, 56b and 56c to the function blocks 52a, 52b and 52c, respectively. The power supply lines 55a/55b/55c and the ground lines 56a/56b/56c are selectively connectable through a switching means 57.

The switching means 57 includes an electro-static discharging circuit 57a and conductive lines 57b selectively connecting the power supply/ground lines 55a/55b/55c and 56a/56b/56c.

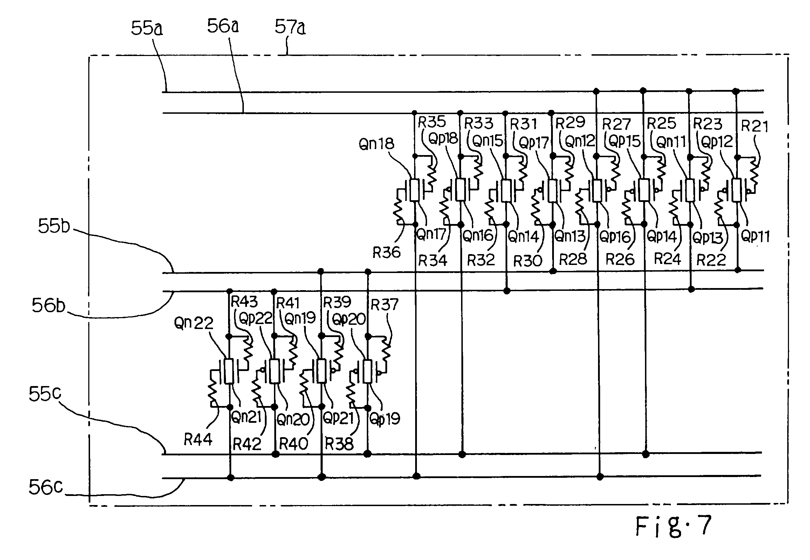

The circuit configuration of the electro-static discharging circuit 57a is illustrated in figure 7. The electro-static discharging circuit 57a includes n-channel enhancement type switching transistors Qn11 to Qn22, p-channel enhancement type switching transistors Qp11 to Qp22 and protective resistors R21 to R44. The n-channel enhancement type switching transistors Qn11 to Qn22 and the p-channel enhancement type switching transistors Qp11 to Qp22 are paired, and the pairs of transistors Qn11-Qn22/Qp11-Qp22 are connected between two of the power supply lines 55a, 55b and 55c, between two of the ground lines 56a, 56b and 56c and between the power supply lines 55a/55b/55c and the ground lines 56a/56b/56c. The protective resistors R21 to R44 are connected between the power supply/ground lines 55a-55c/56a-56c and the gate electrodes of the p-channel/n-channel enhancement type switching transistors Qn11-Qn22/Qp11-Qp22 so as to prevent the gate insulating layers from extremely high surge voltage. Although one more function block 52c is added to the semiconductor integrated circuit device implementing the third embodiment, the switching means 57a is similarly arranged between the three pairs of power supply lines 55a/55b/55c and ground lines 56a/56b/56c, and allows only static surge to pass therethrough.

Although particular embodiments of the present invention have been shown and described, it will be obvious to those skilled in the art that various changes and modifications may be made without departing from the spirit and scope of the present invention.

For example, a semiconductor integrated circuit device may have more than three function blocks. In this instance, a plurality of n-channel enhancement type switching transistors and a plurality of p-channel enhancement type switching transistors are arranged as similar to the electro-static discharging circuit 57a, and allow only static surge to pass therethrough.

The field effect transistors may be replaced with bipolar transistors, and the protective resistors may be deleted from the switching means.

## Claims

1. A semiconductor integrated circuit device comprising:
a first function block (32a; 52a) having a first power supply line (32g; 55a) and a second power supply line (32h; 56a), and causative of a noise on at least one of said first power supply line and said second power supply line;
a second function block (32b) having a third power supply line (32i; 55b) and a fourth power supply line (32j; 56b), and sensitive to said noise;
a first power supply pad (VDD10; VDD21) connected to said first power supply line for supplying a first power potential to said first function block;
a second power supply pad (GND10; GND21) connected to said second power supply line for supplying a second power potential different from said first power potential to said first function block;
a third power supply pad (VDD11; VDD22) connected to said third power supply line for supplying a third power potential to said second function block;
a fourth power supply pad (GND11; GND22) connected to said fourth power supply line for supplying a fourth power potential different from said third power potential to said second function block; and
a discharging means selectively connected to said first, second, third and fourth power supply lines,
characterized in that
said discharging means is implemented by a switching means (35; 41; 57) changed from off-state to on-state for producing a conduction path therebetween in the presence of abnormal potential propagated through one of said first function block and said second function block,
said switching means remaining in said off-state in the presence of said noise propagated through at least one of said first and second power supply lines.

2. The semiconductor integrated circuit device as set forth in claim 1, in which said first, second, third and fourth power supply lines are supplied with a first positive power voltage, a ground voltage, a second positive power voltage and said ground voltage, respectively, and
said switching means (35) includes
a first switching transistor (Qn3) connected between said second power supply line and said third power supply line and responsive to said abnormal potential so as to turn on, thereby discharging said abnormal potential from said second power supply line to said third power supply line,
a second switching transistor (Qn1) connected between said second power supply line and said fourth power supply line and responsive to said abnormal potential so as to turn on, thereby discharging said abnormal potential from said second power supply line to said fourth power supply line, and
a third switching transistor (Qn2) connected between said second power supply line and said fourth power supply line and responsive to said abnormal potential so as to turn on, thereby discharging said abnormal potential from said fourth power supply line to said second power supply line.

3. The semiconductor integrated circuit device as set forth in claim 2, in which said first switching transistor, said second switching transistor and said third switching transistor are a first n-channel enhancement type field effect transistor, a second n-channel enhancement type switching transistor and a third n-channel enhancement type switching transistor, respectively.

4. The semiconductor integrated circuit device as set forth in claim 3, in which said switching means (35) further includes
a first resistor (R13) connected between said second power supply line and the gate electrode of said first n-channel enhancement type field effect transistor,
a second resistor (R11) connected between said second power supply line and the gate electrode of said second n-channel enhancement type field effect transistor, and
a third resistor (R12) connected between said fourth power supply line and the gate electrode of said third n-channel enhancement type field effect transistor.

5. The semiconductor integrated circuit device as set forth in claim 1, in which said first, second, third and fourth power supply lines are supplied with a first positive power voltage, a ground voltage, a second positive power voltage and said ground voltage, respectively, and
said switching means (41; 57a) includes
a first switching transistor (Qp1; Qp12) connected between said first power supply line and said third power supply line and responsive to said abnormal potential so as to turn on, thereby discharging said abnormal potential therebetween,
a second switching transistor (Qp2; Qp11) connected between said first power supply line and said third power supply line and responsive to said abnormal potential so as to turn on, thereby discharging said abnormal potential therebetween,
a third switching transistor (Qn4; Qn11) connected between said first power supply line and said fourth power supply line and responsive to said abnormal potential so as to turn on, thereby discharging said abnormal potential therebetween,
a fourth switching transistor (Qp3; Qp13) connected between said first power supply line and said fourth power supply line and responsive to said abnormal potential so as to turn on, thereby discharging said abnormal potential therebetween,
a fifth switching transistor (Qp4; Qp17) connected between said second power supply line and said third power supply line and responsive to said abnormal potential so as to turn on, thereby discharging said abnormal potential therebetween,
a sixth switching transistor (Qn5; Qn12) connected between said second power supply line and said third power supply line and responsive to said abnormal potential so as to turn on, thereby discharging said abnormal potential therebetween,
a seventh switching transistor (Qn6; Qn15) connected between said second power supply line and said fourth power supply line and responsive to said abnormal potential so as to turn on, thereby discharging said abnormal potential therebetween, and
an eighth switching transistor (Qn7; Qn14) connected between said second power supply line and said fourth power supply line and responsive to said abnormal potential so as to turn on, thereby discharging said abnormal potential therebetween.

6. The semiconductor integrated circuit device as set forth in claim 5, in which said first switching transistor, said second switching transistor, said third switching transistor, said fourth switching transistor, said fifth switching transistor, said sixth switching transistor, said seventh switching transistor and said eighth switching transistor are a first p-channel enhancement type field effect transistor, a second p-channel enhancement type switching transistor, a first n-channel enhancement type switching transistor, a third p-channel enhancement type switching transistor, a fourth p-channel enhancement type switching transistor, a second n-channel enhancement type switching transistor, a third n-channel enhancement type switching transistor and a fourth n-channel enhancement type switching transistor, respectively.

7. The semiconductor integrated circuit device as set forth in claim 6, in which said switching means further includes
a first resistor (R4; R22) connected between said third power supply line and the gate electrode of said first p-channel enhancement type field effect transistor,
a second resistor (R5; R21) connected between said first power supply line and the gate electrode of said second p-channel enhancement type field effect transistor,
a third resistor (R6; R24) connected between said fourth power supply line and the gate electrode of said first n-channel enhancement type switching transistor,
a fourth resistor (R7; R23) connected between said first power supply line and the gate electrode of said third p-channel enhancement type field effect transistor,
a fifth resistor (R8; R30) connected between said third power supply line and the gate electrode of said fourth p-channel enhancement type field effect transistor,
a sixth resistor (R9; R29) connected between said second power supply line and the gate electrode of said second n-channel enhancement type switching transistor,
a seventh resistor (R10; R32) connected between said fourth power supply line and the gate electrode of said third n-channel enhancement type field effect transistor, and
an eighth resistor (R11; R31) connected between said second power supply line and the gate electrode of said fourth n-channel enhancement type field effect transistor.

8. The semiconductor integrated circuit device as set forth in claim 1, in which said first function block includes at least one digital circuit (32c; 52d) powered through said first and second power supply lines and protective circuits (32e; 52g) connected between first signal pads, said at least one digital circuit and said second power supply line so as to discharge said abnormal voltage to said second power supply line, and
said second function block includes at least one analog circuit (32d; 52e) powered through said third and fourth power supply lines and at least one protective circuit (32f; 52h) connected between at least one second signal pad, said fourth power supply line and said at least one analog circuit so as to discharge said abnormal voltage to said fourth power supply line.
